# EUROPÄISCHE PATENTANMELDUNG

(11) **EP 3 557 739 A1**
(43) Veröffentlichungstag der Anmeldung: **23.10.2019**
(21) Anmeldenummer: 18167792.3
(22) Anmeldetag: 17.04.2018
(51) Int. Cl.: H02M 1/14, H02M 1/32

(54) **SPANNUNGSVERSORGUNGSEINRICHTUNG MIT ZWISCHENKREIS, STROMRICHTER UND BREMSCHOPPER**

(71) Anmelder: Siemens Aktiengesellschaft, 80333 München (DE)
(72) Erfinder: Damec, Vladislav, 691 43 Hlohovec (CZ); Schönewolf, Stefan Hans Werner, 90489 Nürnberg (DE)
(74) Vertreter: Maier, Daniel Oliver

(57) **Zusammenfassung**

Spannungsversorgungseinrichtung mit
- zumindest einem Zwischenkreis umfassend zumindest einen Zwischenkreiskondensator (Czk),
- zumindest einem Stromrichter (S), wobei der Stromrichter (S) so mit den Anschlüssen des Zwischenkreises verbunden ist, dass der Stromrichter (S) aus dem Zwischenkreiskondensator (Czk) mit elektrischer Energie gespeist werden kann, und
- zumindest einem Bremschopper (B), der so mit den Anschlüssen des Zwischenkreiskondensators (Czk) verbunden ist, dass elektrische Energie des Zwischenkreiskondensators (Czk) durch den Bremschopper (B) in thermische Energie umgewandelt werden kann.
Dabei ist der Stromrichter (S) mit zumindest einem höher taktenden Halbleiterschalter (H-SiC), insbesondere auf SiC-Basis, ausgestattet, während der Bremschopper (B) mit zumindest einem niedriger taktenden Halbleiterschalter (H-Si), insbesondere auf Si-Basis, ausgestattet ist.

## Beschreibung

### Gebiet der Erfindung

Die Erfindung bezieht sich auf eine Spannungsversorgungseinrichtung mit
- zumindest einem Zwischenkreis umfassend zumindest einen Zwischenkreiskondensator,
- zumindest einem Stromrichter, wobei der Stromrichter so mit den Anschlüssen (z.B. Klemmen) des Zwischenkreises verbunden ist, dass der Stromrichter aus dem Zwischenkreiskondensator mit elektrischer Energie gespeist werden kann und/oder dass der Stromrichter elektrische Energie in den Zwischenkreis einspeisen kann, und
- zumindest einem Bremschopper, der so mit den Anschlüssen des Zwischenkreiskondensators verbunden ist, dass elektrische Energie des Zwischenkreiskondensators durch den Bremschopper in thermische Energie umgewandelt werden kann.

Damit der Stromrichter aus dem Zwischenkreiskondensator mit elektrischer Energie gespeist werden kann und/oder damit der Stromrichter elektrische Energie in den Zwischenkreis einspeisen kann, ist der Zwischenkreis über z.B. eine Netzdrossel bei einem Gleichstrom-Fahrzeug oder über einen weiteren, geeigneten Stromrichter mit dem versorgenden Stromnetz verbunden.

Stromrichter sind Vorrichtungen zur Umwandlung einer eingespeisten, elektrischen Stromart (Gleichstrom, Wechselstrom) in die jeweils andere, oder zur Umwandlung von Wechselstrom in einen Wechselstrom mit geändertem Betrag und/oder geänderter Frequenz und/oder geänderter Phasenlage. Die Umwandlung erfolgt mittels elektronischer Bauteile auf der Basis von Halbleitern, also etwa mit Dioden, Transistoren oder Thyristoren, dabei insbesondere mittels MOSFETs, IGBTs und IGCTs.

Stromrichter zur Umwandlung von Gleichstrom in einen Wechselstrom nennt man Wechselrichter bzw. Pulswechselrichter. Stromrichter zur Umwandlung von Wechselstrom in Gleichstrom nennt man Gleichrichter bzw. Vierquadrantensteller.

Stromrichter zur Umwandlung von Wechselstrom in einen Wechselstrom mit zumindest geänderter Frequenz nennt man Frequenzumrichter.

In elektrisch betriebenen Eisenbahnen werden verschiedene Kombinationen aus oben erwähnten Komponenten (Vierquadrantensteller, Pulswechselrichter) unter der Bezeichnung Traktionsstromrichter eingesetzt, um den Strom aus dem jeweiligen Bahnstromsystem der Oberleitung oder der Stromschiene in den Drehstrom für die stufenlos regelbaren Drehstrom-Antriebsmotoren umzuwandeln. Die Komponenten des Traktionsstromrichters werden über einen oder mehrere Zwischenkreise gekoppelt.

Der Traktionsstromrichter für ein System zum Betrieb an Wechselstromnetzen besteht zumindest aus einem Vierquadrantensteller, zumindest einem mit Gleichspannung betriebenen Zwischenkreis und einem Pulswechselrichter und gegebenenfalls zumindest einem Bremssteller. Bei Betrieb unter einem Gleichspannungsnetz kann auf den Vierquadrantensteller verzichtet werden, stattdessen wird der Zwischenkreis über zumindest eine Netzdrossel mit dem Netz verbunden. Ist der Umrichter in der Lage, in beiden Drehrichtungen Energie aus dem Zwischenkreis zum Motor und beim Bremsen auch zurück in den Zwischenkreis zu übertragen, spricht man von Vierquadrantenbetrieb.

Der Zwischenkreis ist eine elektrische Einrichtung, die als Energiespeicher mehrere elektrische Subsysteme (z.B. Vierquadrantensteller mit Pulswechselrichter) auf einer zwischengeschalteten Strom- oder Spannungsebene elektrisch koppelt. Im Folgenden werden ausschließlich Spannungszwischenkreise (d.h. Zwischenkreise mit Zwischenkreiskondensatoren) betrachtet. Da der Zwischenkreis nur eine bestimmte Energie zerstörungsfrei speichern kann, müssen Maßnahmen zur Reduzierung der gespeicherten Energie getroffen werden. Eine Variante ist die Umwandlung der elektrischen Energie in thermische Energie mit einer Sonderform eines Stromrichters, nämlich einem sogenannten Bremschopper. Meist besteht der Bremsschopper aus einem IGBT als elektronischem Schalter, einem Widerstand und Freilaufdioden. Der elektronische Schalter kann einen Widerstand an den Zwischenkreis zuschalten. Durch periodisches Einschalten (Takten) des Schalters fließt Strom durch den Widerstand und es wird elektrische Energie in Wärme umgesetzt. Dies dient beispielsweise dazu, die Spannung am Zwischenkreis zu begrenzen.

### Stand der Technik

Die Halbleiterschalter in derzeitigen Stromrichtern (eben z.B. Pulswechselrichtern, Vierquadrantenstellern) und Bremschoppern im Eisenbahnbetrieb werden als Si-IGBTs ausgeführt, also als IGBTs auf Siliziumbasis. Solche IGBTs können aufgrund von Beschränkungen der minimalen Leitzeiten, der Schaltzeiten und der Schaltverluste im Anwendungsbereich von Traktionsumrichtern nur mit relativ geringen Schaltfrequenzen betrieben werden, in der Regel mit 100 bis 1500 Hz.

Mittlerweile gibt es bereits SiC-Halbleiterbaubauteile, also Halbleiterbauteile auf Siliziumcarbid-Basis, in den für den Eisenbahn-Stromrichterbereich relevanten Leistungsklassen. Im Vergleich zu Si-IGBTs bzw. Si-Halbleiterbauteilen weisen SiC-Halbleiterbauteile geringere Schaltverluste, geringere Schaltzeiten und geringere Einschränkungen der Leitzeit auf. Dies ermöglicht es, die Schaltfrequenz von SiC-Halbleiterbauteilen im Gegensatz zu Si-Halbleiterbauteilen anzuheben.

SiC-Halbleiterbauteile, wie z.B. SiC-MOSFETs, können also im Anwendungsbereich von Traktionsumrichtern mit höheren Schaltfrequenzen betrieben werden als Si-IGBTs. SiC-MOSFETs können dort z.B. mit 100 - 8000 Hz betrieben werden.

Eine Möglichkeit wäre nun, im Eisenbahnbereich alle Si-IGBTs in den Stromrichtern und den Bremschoppern durch SiC-Halbleiterbauteile, etwa MOSFETs, zu ersetzen und die Schaltfrequenz anzuheben. Dies wäre vorteilhaft für die an den oder die Stromrichter angeschlossenen induktiven Komponenten wie Motoren oder Transformatoren oder Drosseln. Zusätzlich würde dadurch die Spannungswelligkeit (Spannungsripple, engl. ripple) im Zwischenkreis gesenkt werden, die durch das Takten des Bremschoppers verursacht wird. Der Zwischenkreis könnte dann mit einer geringeren Kapazität, also etwa mit einem kleineren Zwischenkreiskondensator, ausgeführt werden.

Neben der Spannungswelligkeit, die durch den Bremschopper verursacht wird, wird die Kapazität des Zwischenkreiskondensators im Eisenbahnbereich durch überlagerte Systemanforderungen bestimmt (z.B. eingangsseitige Impedanz von Netzdrossel und Zwischenkreiskondensator bei einem Gleichstromfahrzeug). Diese und andere Systemanforderungen an die Kapazität des Zwischenkreises dominieren in der Regel über die Anforderung der geringen Spannungswelligkeit. Insofern erscheint daher eine Kombination eines Stromrichters unter Verwendung von SiC-Bauteilen mit einem Bremschopper unter Verwendung von SiC-Bauteilen technisch nicht sinnvoll.

### Aufgabe der Erfindung

Es ist daher eine Aufgabe der vorliegenden Erfindung, den Vorteil von höher taktenden Bauteilen, z.B. SiC-Bauteilen, für eine Spannungsversorgungseinrichtung für Eisenbahnantriebe technisch sinnvoll zu nutzen.

### Darstellung der Erfindung

Diese Aufgabe wird ausgehend von einer Spannungsversorgungseinrichtung mit
- zumindest einem Zwischenkreis umfassend zumindest einen Zwischenkreiskondensator,
- zumindest einem Stromrichter, wobei der Stromrichter so mit den Anschlüssen des Zwischenkreises verbunden ist, dass der Stromrichter aus dem Zwischenkreiskondensator mit elektrischer Energie gespeist werden kann und/oder dass der Stromrichter elektrische Energie in den Zwischenkreis einspeisen kann, und
- zumindest einem Bremschopper, der so mit den Anschlüssen des Zwischenkreiskondensators verbunden ist, dass elektrische Energie des Zwischenkreiskondensators durch den Bremschopper in thermische Energie umgewandelt werden kann,
dadurch gelöst, dass der Stromrichter mit zumindest einem höher taktenden Halbleiterschalter ausgestattet ist, während der Bremschopper mit zumindest einem niedriger taktenden Halbleiterschalter ausgestattet ist.

Mit höher taktend ist gemeint, dass die Taktfrequenz höher ist als beim Halbleiterschalter des Bremschoppers, mit niedriger taktend ist gemeint, dass die Taktfrequenz niedriger ist als beim Halbleiterschalter des Stromrichters (etwa Vierquadrantensteller und/oder Pulswechselrichter).

Insbesondere kann vorgesehen sein, dass der Stromrichter mit zumindest einem höher taktenden Halbleiterschalter auf SiC-Basis ausgestattet ist, während der Bremschopper mit zumindest einem niedriger taktenden Halbleiterschalter auf Si-Basis ausgestattet ist.

Es werden daher der oder die Stromrichter, etwa Pulswechselrichter und/oder Vierquadrantensteller, mit SiC-Halbleiterschaltern, insbesondere SiC-MOSFETs, ausgestattet, während der oder die Bremschopper mit langsamer taktenden Si-Halbleiterschaltern, insbesondere mit Si-IGBTs, ausgestattet werden.

SiC-MOSFETs sind aktuell technisch aufwändiger in der Herstellung und daher aktuell teurer als Si-IGBTs. Für den Einsatz im Pulswechselrichtern oder Vierquadrantenstellern lohnen sich der Mehraufwand und die Zusatzkosten für neuartige SiC-MOSFETs, weil sich dadurch der Wirkungsgrad des Gesamtsystems, bestehend aus Stromrichter und angeschlossenen Komponenten, wie Drosseln, Motoren und Transformatoren, steigern lässt.

Für den Einsatz im Bremschopper hingegen lohnt sich der Einsatz von SiC-MOSFETs weniger, da eine erhöhte Schaltfrequenz in der Regel keinen Vorteil z.B. für den Zwischenkreiskondensator ergibt, da dessen Auslegung von überlagerten Systemanforderungen dominiert wird. Im Gegenteil, soll doch der Bremschopper elektrische Energie in Wärme umsetzen - energieeffiziente SiC-Bauteile wären hier weniger sinnvoll.

Eine Ausführungsform der Erfindung besteht darin, dass der Stromrichter (wie Pulswechselrichter und/oder Vierquadrantensteller) mit zumindest einem SiC-MOSFET ausgestattet ist. Wenn ein Stromrichter über genau einen Halbleiterschalter verfügt, so ist dieser also vorzugsweise als SiC-MOSFET ausgeführt.

Zusätzlich dazu wird vorzugsweise vorgesehen, dass der Bremschopper mit zumindest einem Si-IGBT ausgestattet ist. Wenn der Bremschopper über genau einen Halbleiterschalter verfügt, so ist dieser also vorzugsweise als Si-IGBT ausgeführt.

Eine erfindungsgemäße Spannungsversorgungseinrichtung kann an den Anschlüssen (z.B. Klemmen) des Zwischenkreises mehrere Stromrichter enthalten. Eine Ausführungsform der Erfindung besteht darin, dass zumindest ein Stromrichter als Pulswechselrichter ausgebildet ist. Alternativ oder zusätzlich kann vorgesehen sein, dass zumindest ein Stromrichter als Vierquadrantensteller ausgebildet ist.

Besonders vorteilhaft ist, wenn alle Stromrichter (insbesondere Pulswechselrichter und/oder Vierquadrantensteller) ausschließlich mit (im Vergleich zum Halbleiterschalter des Bremschoppers) höher taktenden Halbleiterschaltern auf SiC-Basis ausgestattet sind.

Besonders vorteilhaft ist, wenn alle Bremschopper ausschließlich mit (im Vergleich zum Halbleiterschalter der Stromrichter) niedriger taktenden Halbleiterschaltern auf Si-Basis ausgestattet sind.

Die erfindungsgemäße Spannungsversorgungseinrichtung findet vorteilhafter Weise Verwendung im Antrieb einer Eisenbahn.

### Kurze Beschreibung der Figuren

Die Erfindung wird nun anhand von bevorzugten Ausführungsbeispielen näher erläutert. Die Zeichnungen sind beispielhaft und sollen den Erfindungsgedanken zwar darlegen, ihn aber keinesfalls einengen oder gar abschließend wiedergeben. Dabei zeigt:
- Fig. 1: eine erfindungsgemäße Spannungsversorgungseinrichtung in einem Gleichspannungsfahrzeug
- Fig. 2: einen erfindungsgemäßen Bremschopper mit Si-IGBT
- Fig. 3: den Strom- und Spannungsverlauf über die Zeit für den Bremschopper aus Fig. 2
- Fig. 4: einen Bremschopper mit SiC-MOSFET
- Fig. 5: den Strom- und Spannungsverlauf über die Zeit für den Bremschopper aus Fig. 4

### Wege zur Ausführung der Erfindung

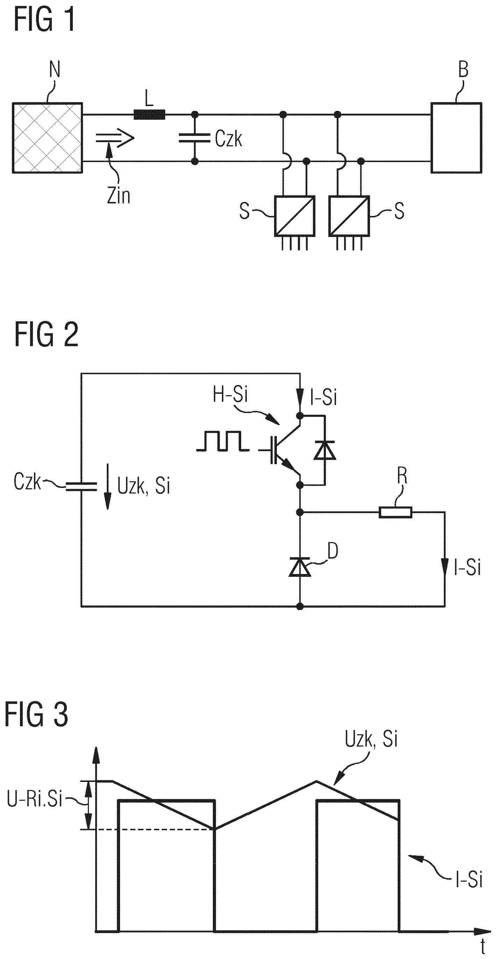

Fig. 1 zeigt eine erfindungsgemäße Spannungsversorgungseinrichtung, die an ein Stromnetz N, hier ein Gleichstromnetz, angeschlossen ist. Netzseitig umfasst die Spannungsversorgungseinrichtung eine Netzdrossel L und einen Zwischenkreis mit einem Zwischenkreiskondensator Czk. In einem mit Wechselspannung versorgten Fahrzeug würde der Zwischenkreis über einen Vierquadrantensteller anstatt der Netzdrossel gespeist, wobei der zumeist vorgelagerte Transformator wieder eine Induktivität darstellen würde.

Vom Stromnetz N aus gesehen weist die Spannungsversorgungseinrichtung eine Eingangsimpedanz Zin auf. An den Klemmen des Zwischenkreiskondensators Czk sind hier zwei Stromrichter S angeschlossen, z.B. Pulswechselrichter und/oder Vierquadrantensteller. Es könnten auch noch weitere Stromrichter angeschlossen sein, wie durch die Punkte angedeutet ist. Weiterhin ist an den Klemmen des Zwischenkreiskondensators Czk zumindest ein Bremschopper B angeschlossen. Es könnten auch noch weitere Bremschopper B angeschlossen sein.

Der Bremschopper B aus Fig. 1 ist in Fig. 2 dargestellt. Der Bremschopper B ist parallel zum Zwischenkreiskondensator Czk geschaltet, am Zwischenkreiskondensator Czk liegt die Spannung Uzk,Si an. Der Bremschopper B umfasst einen Halbleiterschalter H-Si auf Si-Basis, durch den der Strom I-Si fließt. Das Steuersignal für den Halbleiterschalter H-Si ist links von diesem als Rechteckfunktion über der Zeit dargestellt. Weiterhin umfasst der Bremschopper B einen Widerstand R und parallel dazu eine Freilaufdiode D.

In Fig. 3 ist der Strom- und Spannungsverlauf über die Zeit t für den Bremschopper B aus Fig. 2 dargestellt. Der Stromverlauf zeigt den sich aus dem Steuersignal ergebenden periodischen Verlauf des Stroms I-Si durch den Halbleiterschalter H-Si. Daraus ergibt sich der dreieckförmige Verlauf der Spannung Uzk,Si im Zwischenkreis. Der Abstand zwischen höchstem und niedrigstem Spannungswert bezeichnet den Spannungsripple U-Ri,Si (siehe Doppelpfeil) aufgrund des Stroms I-Si.

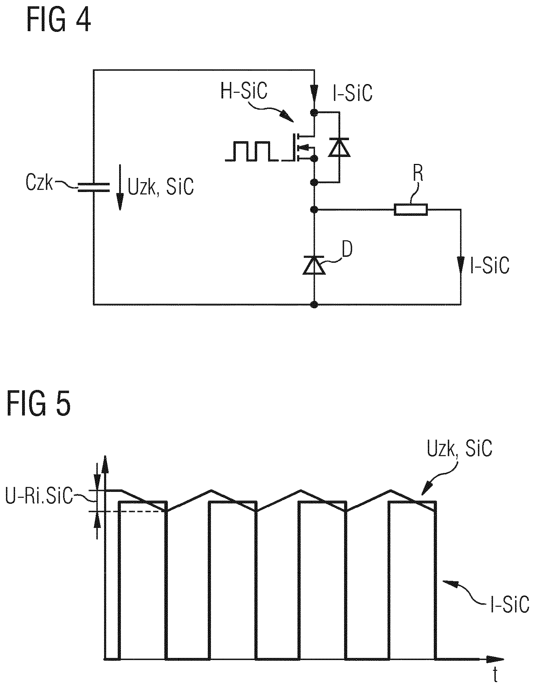

Würde man in den Bremschopper B - so wie in die Stromrichter S - ebenfalls einen Halbleiterschalter H-SiC auf SiC-Basis einbauen, etwa einen SiC-MOSFET, so bleibt die übrige Schaltung wie in Fig. 2 grundsätzlich erhalten, siehe Fig. 4. Allerdings könnte das Steuersignal für den Halbleiterschalter H-SiC, das wieder eine Rechteckfunktion ist, eine höhere Frequenz haben als für den Halbleiterschalter H-Si auf Si-Basis in Fig. 2.

Entsprechend würden sich der Strom I-SiC durch den Halbleiterschalter H-SiC sowie die Spannung Uzk,SiC im Zwischenkreis bzw. am Zwischenkreiskondensator Czk entsprechend ändern, siehe Fig. 5. Dort ist wieder der Strom- und Spannungsverlauf über die Zeit t für den Bremschopper B aus Fig. 4 dargestellt.

Der Stromverlauf zeigt den sich aus dem Steuersignal ergebenden periodischen Stufenverlauf des Stroms I-SiC durch den Halbleiterschalter H-SiC. Der Strom I-SiC hat eine höhere Frequenz als der Strom I-Si in Fig. 3. Entsprechend hat der dreieckförmige Verlauf der Spannung Uzk,SiC im Zwischenkreis eine höhere Frequenz als jener der Spannung Uzk,Si in Fig. 3. Der Abstand zwischen höchstem und niedrigstem Spannungswert bezeichnet die Spannungsripple U-Ri,SiC aufgrund des Stroms I-SiC. Der Spannungsripple ist zwar geringer als jener in Fig. 3, aber die dadurch erreichbaren Vorteile wiegen den Nachteil durch höhere Anschaffungskosten des SiC-Halbleiterschalters H-SiC nicht auf.

### BEZUGSZEICHENLISTE

- B: Bremschopper
- Czk: Zwischenkreiskondensator
- D: Freilaufdiode
- H-Si: Halbleiterschalter auf Si-Basis
- H-SiC: Halbleiterschalter auf SiC-Basis
- I-Si: Strom durch Halbleiterschalter auf Si-Basis
- I-SiC: Strom durch Halbleiterschalter auf SiC-Basis
- L: Netzdrossel
- N: Stromnetz
- R: Widerstand
- S: Stromrichter
- t: Zeit
- U-Ri,Si: Spannungsrippel aufgrund Si-Halbleiterschalter
- U-Ri,SiC: Spannungsrippel aufgrund SiC-Halbleiterschalter
- Uzk,Si: Spannung im Zwischenkreis mit Si-Halbleiterschalter
- Uzk,SiC: Spannung im Zwischenkreis mit SiC-Halbleiterschalter
- Zin: Eingangsimpedanz

## Patentansprüche

1. Spannungsversorgungseinrichtung mit
- zumindest einem Zwischenkreis umfassend zumindest einen Zwischenkreiskondensator (Czk),
- zumindest einem Stromrichter (S), wobei der Stromrichter (S) so mit den Anschlüssen des Zwischenkreises verbunden ist, dass der Stromrichter (S) aus dem Zwischenkreiskondensator (Czk) mit elektrischer Energie gespeist werden kann und/oder dass der Stromrichter elektrische Energie in den Zwischenkreis einspeisen kann, und
- zumindest einem Bremschopper (B), der so mit den Anschlüssen des Zwischenkreiskondensators (Czk) verbunden ist, dass elektrische Energie des Zwischenkreiskondensators (Czk) durch den Bremschopper (B) in thermische Energie umgewandelt werden kann,
**dadurch gekennzeichnet, dass** der Stromrichter (S) mit zumindest einem höher taktenden Halbleiterschalter (H-SiC) ausgestattet ist, während der Bremschopper (B) mit zumindest einem niedriger taktenden Halbleiterschalter (H-Si) ausgestattet ist.

2. Spannungsversorgungseinrichtung nach Anspruch 1, **dadurch gekennzeichnet, dass** der Stromrichter (S) mit zumindest einem höher taktenden Halbleiterschalter (H-SiC) auf SiC-Basis ausgestattet ist, während der Bremschopper (B) mit zumindest einem niedriger taktenden Halbleiterschalter (H-Si) auf Si-Basis ausgestattet ist.

3. Spannungsversorgungseinrichtung nach Anspruch 1 oder 2, **dadurch gekennzeichnet, dass** der Stromrichter (S) mit zumindest einem SiC-MOSFET ausgestattet ist.

4. Spannungsversorgungseinrichtung nach einem der vorhergehenden Ansprüche, **dadurch gekennzeichnet, dass** der Bremschopper (B) mit zumindest einem Si-IGBT ausgestattet ist.

5. Spannungsversorgungseinrichtung nach einem der vorhergehenden Ansprüche, **dadurch gekennzeichnet, dass** zumindest ein Stromrichter (S) als Pulswechselrichter ausgebildet ist.

6. Spannungsversorgungseinrichtung nach einem der vorhergehenden Ansprüche, **dadurch gekennzeichnet, dass** zumindest ein Stromrichter (S) als Vierquadrantensteller ausgebildet ist.

7. Spannungsversorgungseinrichtung nach einem der vorhergehenden Ansprüche, **dadurch gekennzeichnet, dass** alle Stromrichter (S) ausschließlich mit höher taktenden Halbleiterschaltern (H-SiC) auf SiC-Basis ausgestattet sind.

8. Spannungsversorgungseinrichtung nach einem der vorhergehenden Ansprüche, **dadurch gekennzeichnet, dass** alle Bremschopper (B) ausschließlich mit niedriger taktenden Halbleiterschaltern (H-Si) auf Si-Basis ausgestattet sind.

9. Verwendung einer Spannungsversorgungseinrichtung nach einem der Ansprüche 1 bis 8 im Antrieb einer Eisenbahn.
